# EUROPEAN PATENT APPLICATION

(11) **EP 2 757 812 A1**
(43) Date of publication of application: **23.07.2014**
(21) Application number: 12832532.1
(22) Date of filing: 14.09.2012
(51) Int. Cl.: H04R 19/04, B81B 7/02, H01L 29/84

(54) **SEMICONDUCTOR DEVICE AND MICROPHONE**

(30) Priority: 16.09.2011 JP 2011202981
(71) Applicant: Omron Corporation, Kyoto-shi, Kyoto 600-8530 (JP)
(72) Inventor: KURATANI Naoto, Kyoto-shi Kyoto 600-8530 (JP); MAEKAWA Tomofumi, Kyoto-shi Kyoto 600-8530 (JP)
(74) Representative: Isarpatent
(86) International application number: PCT/JP2012/073744
(87) International publication number: WO 2013/039239

(57) **Abstract**

A bump-joining pad (61) is provided to the upper surface of a substrate (45), and a bump (70) of a circuit element (43) is connected to the bump-joining pad. The bump-joining pad (61) is connected to a substrate-side joining section (69) provided to a surface facing a cover by a pattern wiring (64). A microphone chip (42) is mounted on the lower surface of the cover (44). A first joining pad (a bonding pad (48), a cover-side joining section (49)) is provided to a surface of the cover (44) facing the substrate (45), and the microphone chip (42) is connected to the first joining pad by a bonding wire (50). The first joining pad of the cover (44) and the substrate-side joining section (69) of the substrate (45) are joined by a conductive material (65), and as a result, the microphone chip (42) and the circuit element (43) are electrically connected.

## Description

### TECHNICAL FIELD

The present invention relates to a semiconductor device and a microphone, and particularly to a semiconductor device accommodating a semiconductor element inside a package. It also relates to a microphone accommodating a microphone chip (an acoustic sensor) inside a package.

### BACKGROUND ART

With respect to electronic appliances, especially portable appliances, there is a demand for miniaturization of the appliances, and thus, parts have to be mounted at high density on a small circuit board. To enable high-density mounting of parts, areas occupied by the parts for mounting (hereinafter "mounting area") have to be made small. However, in the case of an MEMS microphone, a microphone chip and a circuit element are mounted inside a package, and with a conventional microphone, the microphone chip and the circuit element are arranged next to each other on the same surface of the substrate or the cover of the package. Thus, there is a restriction on reduction in the mounting area of the microphone, and it is difficult to reduce the mounting area.

For example, according to a microphone described in Patent Document 1, a circuit element and a microphone chip are mounted next to each other on the top surface of a cover, and a wiring pattern is provided on the side wall of the inner surface of the cover. Moreover, the microphone chip and the circuit element are connected by a bonding wire, an end portion of the wiring pattern positioned on the top surface of the cover and the circuit element are connected by the bonding wire, and the cover is placed on the substrate to thereby connect the other end of the wiring pattern to the substrate.

Also, according to a microphone described in Patent Document 2, a circuit element and a microphone chip are mounted on the inner surface of a cover and the circuit element and the microphone chip are connected by a bonding wire, the circuit element and the microphone chip are connected to an electrode pad on the inner surface of the cover by the bonding wire, and the electrode pad of the cover is connected to a substrate through a through hole and a coil spring provided inside a side wall (a side substrate) of the cover.

According to the structure of Patent Document 1 or 2, the circuit element and the microphone chip are arranged next to each other, and the plane area of the microphone is large, and the mounting area for mounting the microphone on a circuit board or the like is large.

Furthermore, as a conventional microphone, there is also a microphone having a substrate and a cover forming a package. A circuit element is mounted on the upper surface of the substrate and a microphone chip is mounted on the top surface of the cover. A microphone having such a structure is disclosed in Patent Document 3 and Patent Document 4.

According to the microphone described in Patent Document 3, a circuit element and a metal for shielding are arranged next to each other on the upper surface of a substrate, and a microphone chip is arranged on the top surface of a cover, at a position directly above the metal for shielding. Accordingly, when the microphone is seen from vertically above, the microphone chip and the circuit element are not overlapped with each other. In this manner, according to the microphone of Patent Document 3, although the circuit element and the microphone chip are vertically arranged, the microphone is not directed to the reduction in the mounting area, and not configured to reduce the mounting area.

Moreover, a circuit element and a microphone chip have to be connected inside a package, but in the case of mounting the circuit element on a substrate and the microphone chip on a cover, the connection method becomes an issue. For example, if the circuit element mounted on the substrate and the microphone chip mounted on the cover are connected by a bonding wire, and then, the cover is placed on the substrate, the circuit may be shorted by a slack in the bonding wire. However, the wiring method of connecting the circuit element and the microphone chip is not disclosed in Patent Document 3.

A microphone 11 described in Patent Document 4 is shown in Fig. 1. According to this microphone 11, a pad 13 is provided on the upper surface of a substrate 12, and a bump 15 provided on the lower surface of a circuit element 14 is joined to the pad 13 to mount the circuit element 14 on the substrate 12. A pad 17 is provided to the lower surface of a cover 16, and a bump 19 provided on the upper surface of a microphone chip 18 is joined to the pad 17 to mount the microphone chip 18 on the cover 16. Moreover, the pad 13 on the substrate 12 and the pad 17 on the cover 16 are electrically connected with each other by each of wirings 21, 22 and 23 for connection provided on the substrate 12, a side wall 20, and the inner surface of the cover 16.

According to such a structure, the plane area of the microphone 11 may possibly be reduced by vertically arranging the microphone chip 18 and the circuit element 14. On the other hand, since the circuit element 14 and the microphone chip 18 are connected by the wirings 21 to 23 for connection that are wired through the substrate 12, the side wall 20, and the cover 16, the wiring length is increased. Thus, there is a problem that the parasitic capacitance between the wirings 21 to 23 for connection and the substrate 12, the side wall 20 and the cover 16 becomes great, and that the sensitivity of the microphone 11 may be reduced.

A microphone 31 described in Patent Document 5 is shown in Fig. 2. According to this microphone 31, a circuit element 33 is mounted on the upper surface of the substrate 32, and a microphone chip 35 is mounted on the lower surface of a top plate 34. Moreover, the wiring of the substrate 32 and the wiring of the top plate 34 are connected by a coupling member 36 provided between the substrate 32 and the top plate 34, and the circuit element 33 and the microphone chip 35 are connected by the wirings of the substrate 32 and the top plate 34 and the coupling member 36. Furthermore, the circuit element 33, the microphone chip 35, the coupling member 36, the top plate 34 and the like are covered by a cover 37 placed on the substrate 32.

Miniaturization of the microphone 31 is also achieved by such a microphone 31. However, with this structure, additional members such as the top plate 34 and the coupling member 36 are necessary, and the cost of the microphone 31 is increased. Moreover, there is also the parasitic capacitance between the top plate 34 and the coupling member 36, in addition to the parasitic capacitance between the substrate 32 and the cover 37, and the sensitivity of the microphone 31 is reduced.
Patent Document 1: US 2008/0283988 A
Patent Document 2: US 2007/0058826 A
Patent Document 3: US 7,166,910 (Fig. 9, Fig. 10)
Patent Document 4: US 2011/0075875 A (Fig. 4)
Patent Document 5: US 2010/0290644 A (Fig. 1)

### SUMMARY OF THE INVENTION

### PROBLEMS TO BE SOLVED BY THE INVENTION

The present invention has been made in view of the technical problem as described above, and its object is to provide a semiconductor device and a microphone, where a microphone chip or other semiconductor elements, and a circuit element are vertically placed, according to which the parasitic capacitance of a wiring connecting a semiconductor element and a circuit element may be reduced, and according to which short-circuiting of wirings for connection does not easily occur.

### MEANS FOR SOLVING THE PROBLEM

A semiconductor device according to the present invention is a semiconductor device including a package formed from a first member and a second member, the package having a space formed inside, and a sensor and a circuit element that are accommodated inside the package, wherein a first joining pad is provided at a joining portion of the first member to the second member, wherein a bump-joining pad for connecting a bump is provided to the second member, and also, a second joining pad in conduction with the bump-joining pad is provided to a joining portion of the second member to the first member, wherein one element among the sensor and the circuit element is mounted on the first member, and the one element and the first joining pad are connected by a wiring, wherein a bump is provided to another element among the sensor and the circuit element, and the bump is connected to the bump-joining pad and the another element is mounted on the second member, wherein the sensor and the circuit element are arranged while being at least partially overlapped with each other when seen from a direction vertical to a bottom surface of the package, and wherein the package is formed by joining the first member and the second member, and the first joining pad and the second joining pad are joined by a conductive material.

This semiconductor device serves as a microphone that detects acoustic vibration in a case a microphone chip is used as the sensor, and an acoustic perforation is formed on one member among the first member and the second member. Also, as the bump, a solder bump, an Au bump, a bump of other conductive material, or a bump formed of an anisotropic conductive material may be used.

The semiconductor device of the present invention has the sensor and the circuit element accommodated inside the package, and the sensor and the circuit element are vertically arranged in such a way that they are at least partially overlapped when seen from a direction vertical to the bottom surface of the package, and thus, the plane area of the package of the semiconductor device may be made small, and the mounting area of the semiconductor device may be made small. Furthermore, according to the semiconductor device of the present invention, no wiring is used for the second member, and thus, the height of the semiconductor device may be reduced.

Also, according to the semiconductor device of the present invention, the sensor and the circuit element may be connected by joining, by a conductive material, one element, among the sensor and the circuit element, that is mounted on and wired to the first member and the other element that is bump-connected to the second member and mounted on the second member, and thus, the sensor and the circuit element may be connected by a simple wiring structure and a simple assembly method.

Also, since one element is wired and the other element is bump-connected, contact between wirings is less likely to occur, and the yield rate of the semiconductor device is improved. Moreover, since the one element is connected to the first member by a wiring, the length of wiring between the sensor and the circuit element may be made short, and the parasitic capacitance between the wiring portion and the package may be made small. In this manner, according to the semiconductor device of the present invention, suppression of parasitic capacitance of the package and prevention of short-circuiting at the wiring portion may be achieved in a balanced manner by using wiring and bump-connection in combination.

According to an aspect of the semiconductor device of the present invention, the one element is the sensor and the other element is the circuit element. According to this aspect, the circuit element is connected to the second member by a bump, and the circuit element is flip mounted on the second member. Thus, the circuit element is mounted face-down with the circuit formed surface (the surface where the bump is provided) facing the second member, and light entering the package is less likely to be radiated on the circuit surface of the circuit element. As a result, the optical noise immunity of the circuit element or the semiconductor device is improved. Moreover, since the circuit element does not have to be covered by a light-shielding resin as a countermeasure against optical noise, the height of the semiconductor device may be reduced, and the cost may be reduced.

According to another aspect of the semiconductor device of the present invention, the second joining pad is arranged on the second member in one direction when seen from the another element, and the another element is arranged at a position closer to the second joining pad than a center of the second member. According to such an aspect, the distance between the bump-joining pad and the second joining pad may be made short, and the parasitic capacitance to the package may be made small, and the sensor sensitivity may be increased.

According to further another aspect of the semiconductor device of the present invention, the first member includes a plurality of the first joining pads, and the one element and the first joining pads are connected by a plurality of wirings, and a width of the another element is narrower than a gap between the wirings, and the another element is positioned in the gap between the wirings. According to such an aspect, the distance between the bump-joining pad and the second joining pad may be reduced as much as possible, and the parasitic capacitance to the package may be made small, and the sensor sensitivity may be increased.

According to still another aspect of the semiconductor device of the present invention, the bump-joining pad and the second joining pad are connected by a conductive wiring provided to the second member. According to such an aspect, the wiring of the second member does not protrude into the space inside the package like a wire, and does not come into contact with the wiring of the first member.

According to still another aspect of the semiconductor device of the present invention, the first joining pad is formed from a bonding pad provided to the first member, at a portion facing the second member, and a joining section in conduction with the bonding pad, and the wiring is connected to the bonding pad, and the joining section is joined to the second joining pad by the conductive material. According to such an aspect, the first joining pad may be separated into a region for connecting the wiring (the bonding pad) and a region for joining to the second joining pad (the joining section), and the assembling of the semiconductor device is facilitated. Especially, if the bonding pad and the joining section are formed of a continuous metal film, and the bonding pad and the first joining section are separated by partially covering a surface of the metal film by an insulating film, the conductive material for joining the joining section is less likely to extend to the bonding pad.

According to still another aspect of the semiconductor device of the present invention, the sensor is positioned vertically above or vertically below the circuit element. According to such an aspect, the mounting area of the semiconductor device may be made extremely small.

According to still another aspect of the semiconductor device of the present invention, the first member is a cover of the package, and the second member is a substrate of the package. According to such an aspect, bump-connection is on the substrate side, and wire connection is on the cover side, and the structure of the semiconductor device is simplified.

Additionally, the means for solving the problems of the present invention has characteristics obtained by appropriately combining the structural elements described above, and numerous variations of the present invention are made possible by combining the structural elements.

### BRIEF DESCRIPTION OF THE DRAWINGS

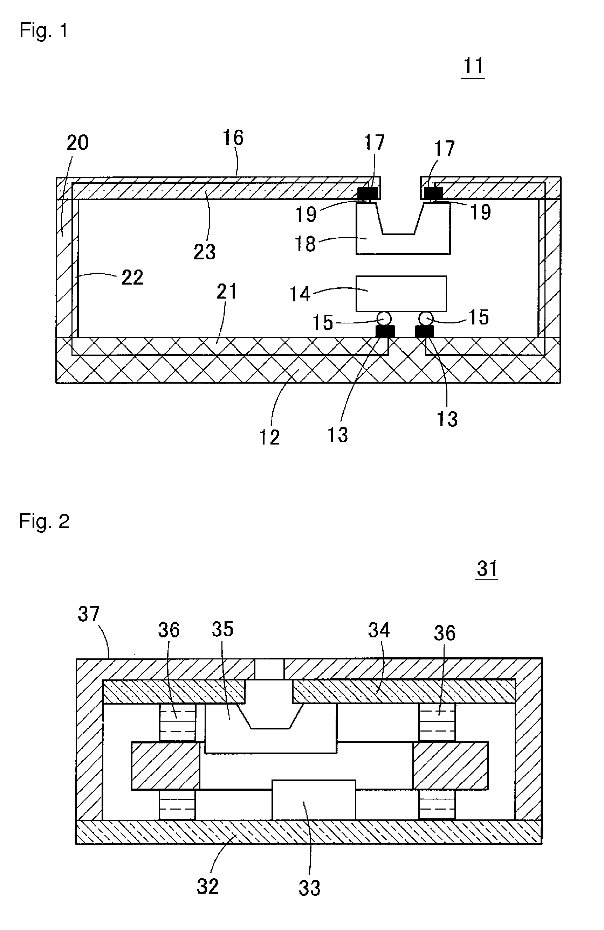

Fig. 1 is a cross-sectional diagram of a microphone described in Patent Document 4;
Fig. 2 is a cross-sectional diagram of a microphone described in Patent Document 5;
Fig. 3(A) is a plan view of a substrate on which a circuit element according to First Embodiment is mounted, and Fig. 3(B) is a bottom view of a cover on which a microphone chip according to First Embodiment is mounted;
Fig. 4(A) is a plan view of the substrate according to First Embodiment, and Fig. 4(B) is a bottom view of the cover according to First Embodiment;
Fig. 5(A) is a plan view of the substrate according to First Embodiment from which a solder resist has been removed, and Fig. 5(B) is a bottom view of the cover according to First Embodiment from which a solder resist has been removed;
Fig. 6 is a cross-sectional diagram of a microphone according to First Embodiment, and shows a cross section at a portion corresponding to line X1-X1 in Figs. 3(A) and 3(B);
Fig. 7(A) is a plan view of a substrate on which a circuit element according to Second Embodiment is mounted, and Fig. 7(B) is a bottom view of a cover on which a microphone chip according to Second Embodiment is mounted;
Fig. 8 is a cross-sectional diagram of a microphone according to Second Embodiment, and shows a cross section at a portion corresponding to line X2-X2 in Figs. 7(A) and 7(B);
Fig. 9(A) is a plan view of a substrate on which a circuit element according to an example modification of Second Embodiment is mounted, and Fig. 9(B) is a bottom view of a cover on which a microphone chip according to the example modification of Second Embodiment is mounted;
Fig. 10 is a cross-sectional diagram of a microphone according to the example modification of Second Embodiment, and shows a cross section at a portion corresponding to line X3-X3 in Figs. 9(A) and 9(B);
Fig. 11 (A) is a plan view of a substrate on which a circuit element according to Third Embodiment is mounted, and Fig. 11 (B) is a bottom view of a cover on which a microphone chip according to Third Embodiment is mounted;
Fig. 12 is a cross-sectional diagram of a microphone according to Third Embodiment, and shows a cross section at a portion corresponding to line X4-X4 in Figs. 11 (A) and 11 (B);
Fig. 13(A) is a plan view of a substrate on which a circuit element according to Fourth Embodiment is mounted, and Fig. 13(B) is a bottom view of a cover on which a microphone chip according to Fourth Embodiment is mounted;
Fig. 14 is a cross-sectional diagram of a microphone according to Fourth Embodiment, and shows a cross section at a portion corresponding to line X5-X5 in Figs. 13(A) and 13(B); and
Fig. 15 is a cross-sectional diagram of a microphone according to Fifth Embodiment.

### DESCRIPTION OF SYMBOLS

- 41, 81 to 83, 87, 88: Microphone
- 42: Microphone chip
- 43: Circuit element
- 44: Cover
- 45: Substrate
- 46: Recessed section
- 48: Bonding pad
- 49: Cover-side joining section
- 50: Bonding wire
- 61: Bump-joining pad
- 64: Pattern wiring
- 65: Conductive material
- 66: Conductive material
- 69: Substrate-side joining section
- 70: Bump
- 84: Recessed section

### MODE FOR CARRYING OUT THE INVENTION

Hereinafter, preferred embodiments of the present invention will be described with reference to the accompanying drawings. However, the present invention is not restricted to the following embodiments, and various modifications in design can be made without departing from the spirit of the present invention.

### (First Embodiment)

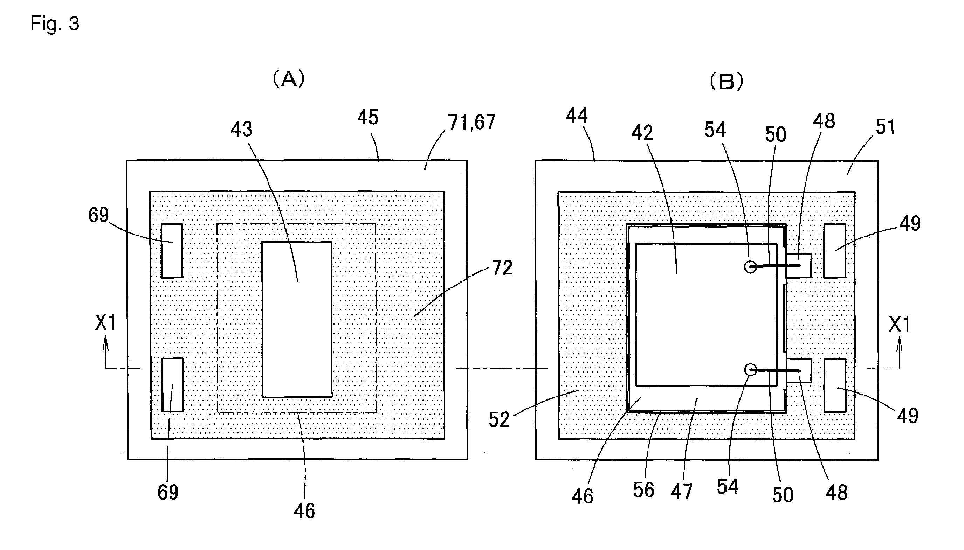

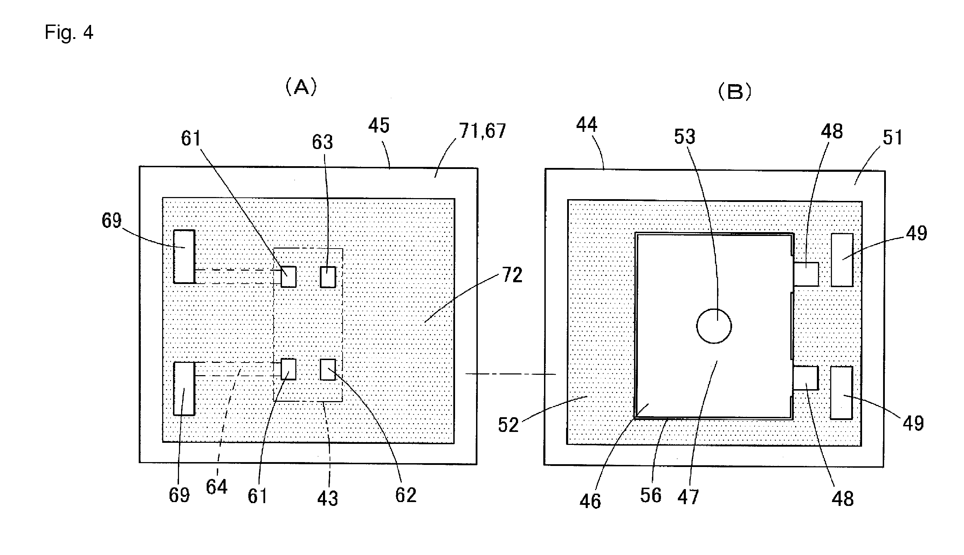

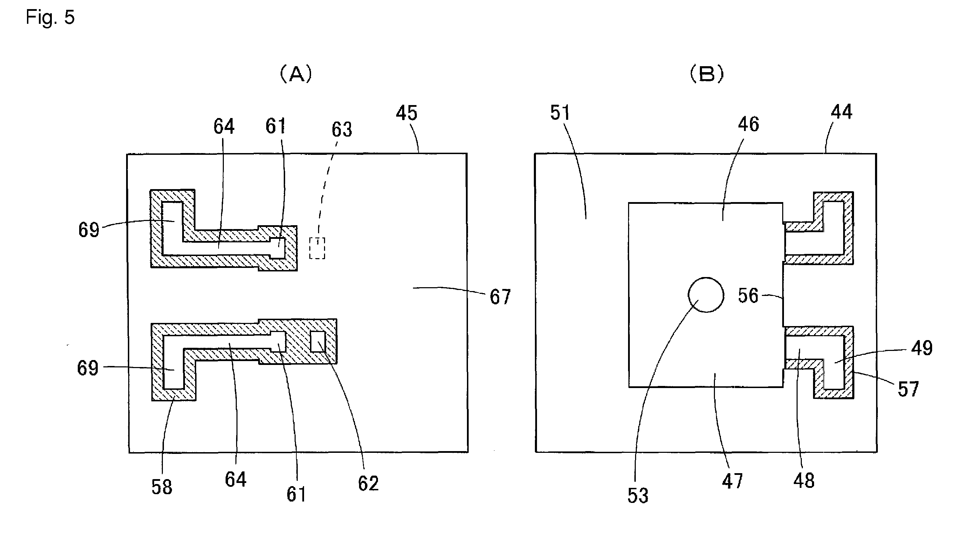

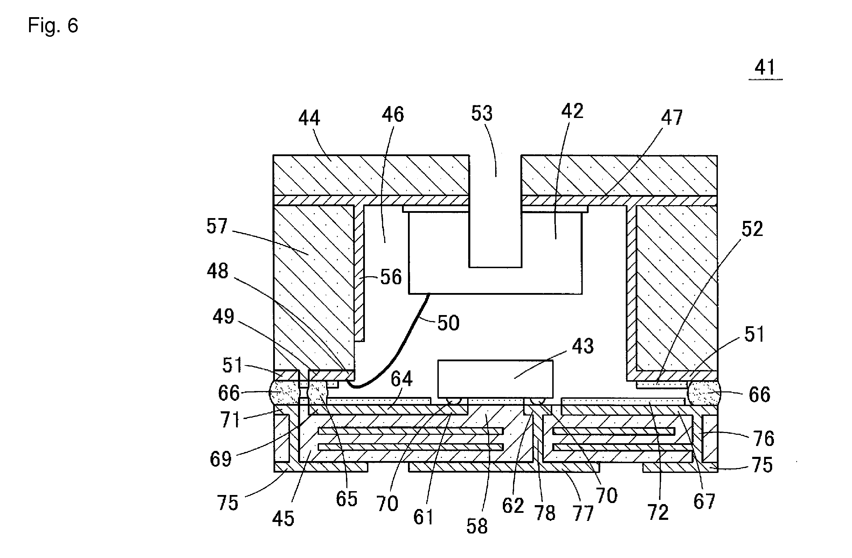

A top-port microphone 41 according to First Embodiment of the present invention will be described with reference to Figs. 3(A) and 3(B) to Fig. 6. The microphone 41 is a MEMS microphone that is fabricated using a MEMS technique, and accommodates a microphone chip 42 (a sensor) and a circuit element 43 inside a package formed from a cover 44 (a first member) and a substrate 45 (a second member). Also, the microphone 41 of First Embodiment is a top-port type with an acoustic perforation 53 formed on the cover 44. Fig. 3(A) is a plan view of the substrate 45 on which the circuit element 43 is mounted, and Fig. 3(B) is a bottom view of the cover 44 on which the microphone chip 42 is mounted. Fig. 4(A) is a plan view of the substrate 45 before the circuit element 43 is mounted, and Fig. 4(B) is a bottom view of the cover 44 before the microphone chip 42 is mounted. Fig. 5(A) is a plan view of the substrate 45 from which a solder resist 72 has been removed, and Fig. 5(B) is a bottom view of the cover 44 from which a solder resist 52 has been removed. Also, Fig. 6 is a cross-sectional diagram of the microphone 41 at a portion corresponding to line X1-X1 in Figs. 3(A) and 3(B).

As shown in Fig. 6, the cover 44 is a multilayer wiring board, a copper clad laminate, a glass epoxy substrate, a ceramic substrate, a plastic substrate, a metal substrate, a carbon nanotube substrate, or a composite substrate formed from the above, the cover 44 including one layer of metal foil (a conductive layer 47) on the inside and one layer of metal foil (a layer to be a bonding pad 48, a cover-side joining section 49 (a joining section), and a ground joining section 51) on the lower surface. Alternatively, two glass epoxy substrates or copper clad laminates that are stacked and integrated, with a metal foil placed on the surface, may also be used. Parts of the cover 44 other than the metal foil are of an insulating material 57. Also, the cover 44 may be formed of ceramic or plastic, one layer of metal plate (the conductive layer 47) may be embedded inside, and one metal plate (a layer to be the bonding pad 48, the cover-side joining section 49, and the ground joining section 51) may be adhered to the surface.

A box-shaped recessed section 46 for accommodating a microphone chip 42 is provided at the center of the lower surface of the cover 44. A metal foil at the top, that is, the conductive layer 47 is exposed at the top side of the recessed section 46, and the outer peripheral portion of the conductive layer 47 is horizontally sandwiched inside the cover 44. A metal foil positioned at the lower surface of the cover 44 is separated, as shown in Fig. 5(B), into first joining pads and other parts. The first joining pads are formed from the bonding pads 48 and the cover-side joining sections 49, and parts other than the first joining pads are the ground joining section 51. As shown in Fig. 6, a conductive layer 56 is formed on the inner peripheral wall surface of the recessed section 46 in such a way as to be in conduction with the conductive layer 47 and the ground joining section 51, and an electromagnetic shield section (a ground section) is configured by the conductive layers 47 and 56, and the ground joining section 51.

As shown in Fig. 4(B), the outer peripheral portion of the recessed section 46, that is, the lower surface of the cover 44, is covered by a solder resist 52, and the bonding pad 48 and the cover-side joining section 49 are separately provided to the lower surface of the cover 44 in such a way as to be exposed from the solder resist 52. Furthermore, the outer peripheral portion of the ground joining section 51 is also exposed from the solder resist 52.

The ground joining section 51, the bonding pad 48, and the cover-side joining section 49 are one layer of metal foil, but as shown in Fig. 5(B), the peripheries of the bonding pad 48 and the cover-side joining section 49 are separated from the ground joining section 51, and each of the bonding pad 48 and the cover-side joining section 49 is electrically insulated from the ground joining section 51. On the other hand, the bonding pad 48 and the cover-side joining section 49 which are the first joining pads, are in electrical conduction with each other below the solder resist 52. Additionally, the hatched portions in Fig. 5(B) are portions of the cover 44 where the metal film is removed and the insulating material 57 is exposed.

The microphone chip 42 is an MEMS element (an acoustic sensor), and a thin-film diaphragm for acoustic vibration detection is provided to an opening of an Si substrate, and a canopy-shaped back plate is fixed to the Si substrate, facing the diaphragm, for example. Also, a capacitor for outputting detection signals is configured from a fixed electrode film provided to the back plate and the diaphragm (both are formed of polysilicon), and a large number of acoustic holes for introducing acoustic vibration into an air gap between the fixed electrode film and the diaphragm are formed on the back plate.

As shown in Fig. 6, the microphone chip 42 is accommodated inside the concave portion 46, and its underside is fixed to the top side of the concave portion 46 (the conductive layer 47) by an adhesive. Also, the microphone chip 42 is installed in alignment with an acoustic perforation 53 opened on the cover 44, and covers the acoustic perforation 53. Accordingly, the microphone chip 42 may have a large back chamber capacity with the opening portion of the Si substrate and the acoustic perforation 53 being a front chamber and the space inside the package being a back chamber, and the sensitivity of the microphone chip 42 may be increased. As shown in Figs. 3(B) and 6, a terminal 54 provided on the surface of the microphone chip 42 is connected to the bonding pad 48 by a bonding wire 50 (a wiring).

As shown in Fig. 6, the substrate 45 is a multilayer wiring board, a copper clad laminate, a glass epoxy substrate, a ceramic substrate, a plastic substrate, a metal substrate, a carbon nanotube substrate, or a composite substrate formed from the above. As shown in Fig. 5(A), a conductive layer 67 for electromagnetic shielding is formed on almost the entire substrate 45.

As shown in Fig. 4(A), a region, on the upper surface of the substrate 45, other than a circuit element mounted area and the outer peripheral portion is covered by a solder resist 72, and a plurality of bump-joining pads 61, bump pads 62 and 63, and substrate-side joining sections 69 (second joining pads) are provided on the upper surface of the substrate 45 in such a way as to be exposed from the solder resist 72. Also, the outer peripheral portion of the conductive layer 67 exposed from the solder resist 72 is a ground joining section 71. Here, the bump-joining pad 61 and the bump pads 62 and 63 are pads for bump-joining the circuit element 43. Furthermore, the bump-joining pad 61 is a pad for connecting the circuit element 43 to the microphone chip 42, the bump pad 62 is a pad for connecting the circuit element 43 to a signal input/output terminal 77 on the lower surface, and the bump pad 63 is a pad for ground connection.

The conductive layer 67, the bump-joining pad 61, the bump pads 62 and 63, and the substrate-side joining section 69 are metal films. As shown in Fig. 5(A), the bump-joining pad 61 and the substrate-side joining section 69 are connected and electrically conducted by a pattern wiring 64 (a conductor wiring) below the solder resist 72. The surroundings of the bump-joining pad 61, the pattern wiring 64, and the substrate-side joining section 69 and the surroundings of the bump pad 62 are separated from the conductive layer 67, and the bump-joining pad 61, the pattern wiring 64, the substrate-side joining section 69, and the bump pad 62 are each electrically insulated from the conductive layer 67. Also, the bump pad 63 is a part of the conductive layer 67, and is in conduction with the conductive layer 67 (the ground joining section 71). Additionally, the hatched portions in Fig. 5(A) are portions of the substrate 45 where the metal film is removed and an insulating material 58 is exposed.

The circuit element 43 is an element such as an ASIC or an IC chip. The circuit element 43 has an electric circuit (not shown) and bumps 70 formed on its upper surface. The bump 70 is a bump such as a solder bump, an Au bump, a bump of other conductive material, or a bump formed of an anisotropic conductive material (for example, AGF, conductive tape or the like). As shown in Figs. 3(A) and 6, the circuit element 43 is placed on the substrate 45 with its upper surface facing down, and is flip-chip mounted by the bumps 70 bump-connected to the bump-joining pad 61 and the bump pads 62 and 63 of the substrate 45.

A ground terminal 75 is provided on the lower surface of the substrate 45, and the ground terminal 75 is linked to the conductive layer 67 through a via hole 76. Accordingly, the bump 70 of the circuit element 43 connected to the bump pad 63 is in conduction with the ground terminal 75 through the via hole 76. Also, the signal input/output terminal 77 for signal input/output is provided on the lower surface of the substrate 45, and the signal input/output terminal 77 is linked to the bump pad 62 through a via hole 78. Accordingly, the bump 70 of the circuit element 43 connected to the bump pad 62 is in conduction with the signal input/output terminal 77 through the via hole 78. Also, the bump 70 of the circuit element 43 connected to the bump-joining pad 61 is in conduction with the substrate-side joining section 69 through the pattern wiring 64.

As shown in Fig. 6, the cover 44 is stacked on the upper surface of the substrate 45 with the recessed section 46 facing down, and the cover-side joining section 49 and the substrate-side joining section 69 facing each other are joined by a conductive material 65. As the conductive material 65, any one of a conductive adhesive, solder, a two-sided conductive adhesive tape, and a brazing filler metal for welding may be used, or a plurality of materials among the above may be used in combination. The outer peripheral region of the ground joining section 51 and the ground joining section 71 provided at the outer peripheral portion on the upper surface of the substrate 45 are joined along the whole perimeter by a conductive material 66. As the conductive material 66, any one of a conductive adhesive, solder, a two-sided conductive adhesive tape, and a brazing filler metal for welding may be used, or a plurality of materials among the above may be used in combination. Non-conductive resin or a non-conductive tape may further be used in combination to adhere the cover 44 and the substrate 45 to each other.

As a result, the microphone chip 42 and the circuit element 43 are sealed inside a package formed from the cover 44 and the substrate 45 in an airtight manner. Also, the conductive layers 47 and 56 and the ground joining section 51 of the cover 44 are in electrical conduction with the conductive layer 67 of the substrate 45 by the ground joining section 51 and the ground joining section 71 being joined by the conductive material 66, and thus, by connecting the ground terminal 75 to an earth line of a circuit board or the like, the conductive layers 47, 56 and 67, and the ground joining section 51 are maintained at ground potential, and the microphone 41 is blocked from external electromagnetic noise.

Since the cover-side joining section 49 and the substrate-side joining section 69 are joined via the conductive material 65, the microphone chip 42 is connected to the circuit element 43 through the route of the bonding wire 50 → the bonding pad 48 → the cover-side joining section 49 → the conductive material 65 → the substrate-side joining section 69 → the pattern wiring 64 → the bump-joining pad 61.

According to the microphone 41 with such a structure, the microphone chip 42 is mounted on the cover 44, the circuit element 43 is mounted on the substrate 45, and the microphone chip 42 is arranged directly above the circuit element 43 in a stacking manner, and thus, a package with a small base area may be used. As a result, the microphone 41 with an extremely small mounting area may be fabricated.

According to this microphone 41, the microphone chip 42 and the circuit element 43 are electrically connected by connecting the bonding wire 50 from the microphone chip 42 to the bonding pad 48 provided on the lower surface of the cover 44, bump-connecting the circuit element 43 to the upper surface of the substrate 45, and joining the cover-side joining section 49 and the substrate-side joining section 69 by the conductive material 65 at the time of joining the cover 44 to the substrate 45. Also, according to this microphone 41, if the cover 44 is turned over such that the bonding pad 48 is at the top, the bonding pad 48 will be positioned on the surface of the cover 44, and thus, the bonding wire 50 may be easily connected to the bonding pad 48 or the terminal 54 of the microphone chip 42 using a wire bonder. The circuit element 43 may also be easily bump-connected to the bump-joining pad 61 and the bump pads 62 and 63 in the same manner. Accordingly, with the microphone 41, the microphone chip 42 on the cover 44 and the circuit element 43 on the substrate 45 may be electrically connected by a simple wiring structure and a simple assembly method.

The applicant of the present invention has filed a patent application as Japanese Patent Application No. 2010-125527 according to which a microphone chip and a circuit element are mounted on a cover and a substrate and the microphone chip and the circuit element are vertically arranged such that the mounting area of a microphone is reduced. According to the microphone of this patent application, the microphone chip and the cover are connected by a bonding wire, the circuit element and the substrate are connected by a bonding wire, and the two bonding wires are serially connected at a connection portion of the cover and the substrate to connect a terminal of the microphone chip and a terminal of the circuit element. According to this structure, the length of the wiring connecting the microphone chip and the circuit element may be made short, and the parasitic capacitance of the cover and the substrate may be reduced to minimum. However, since the number of bonding wires is increased, the bonding wires are more likely to interfere with each other. As a result, short-circuiting may occur due to the bonding wires of adjacent terminals coming into contact with each other. Also, when the bonding wire on the microphone chip side and the bonding wire on the circuit element side come into contact with each other, the impedance of the wiring portion between the microphone chip and the circuit element may be reduced.

In contrast, according to the microphone 41 of First Embodiment of the present invention, the microphone chip 42 and the cover 44 are connected by the bonding wire 50, but the circuit element 43 and the substrate 45 are bump-connected, and thus, short-circuiting due to the bonding wires 50 on the microphone chip 42 side coming into contact is less likely to occur. Also, the wiring on the microphone chip 42 side (the bonding wire 50) and the wiring on the circuit element 43 side (the bump-joining pad 61, the pattern wiring 64, the substrate-side joining section 69, and the like) will not come into contact. As a result, the yield rate of the microphone 41 may be improved.

Also, since the microphone chip 42 and the cover 44 are connected by the bonding wire 50, and the length of the wiring between the microphone chip 42 and the circuit element 43 may be made short, the parasitic capacitance between the wiring portion and the package may be made small, and reduction in the sensitivity of the microphone 41 may be suppressed.

Furthermore, according to the microphone 41 of First Embodiment of the present invention, the circuit element 43 is flip-chip mounted with its surface where the circuit is formed facing the substrate 45, and thus, even if light which has entered the package from the acoustic perforation 53 passes through the microphone chip 42, the light is not radiated on the circuit of the circuit element 43. Thus, the optical noise immunity of the microphone 41 is improved.

According to the microphone 41 of First Embodiment of the present invention, since short-circuiting is unlikely to occur due to the microphone chip 42 and the cover 44 being connected by the bonding wire 50 and the circuit element 43 and the substrate 45 being bump-connected, the height of the microphone 41 may be reduced. Also, because of the structure by which light is not likely to be radiated on the circuit surface of the circuit element 43, the circuit element 43 does not have to be covered by a light-shielding resin such as black resin as a countermeasure against optical noise. Thus, the height of the microphone 41 may be further reduced, and an advantage regarding reduction in the cost may also be obtained.

### (Second Embodiment)

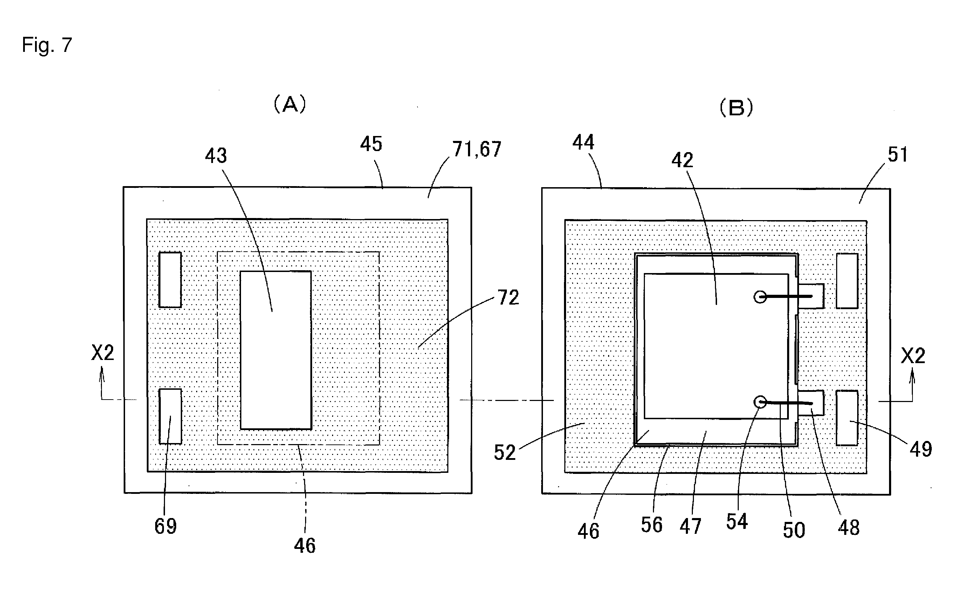

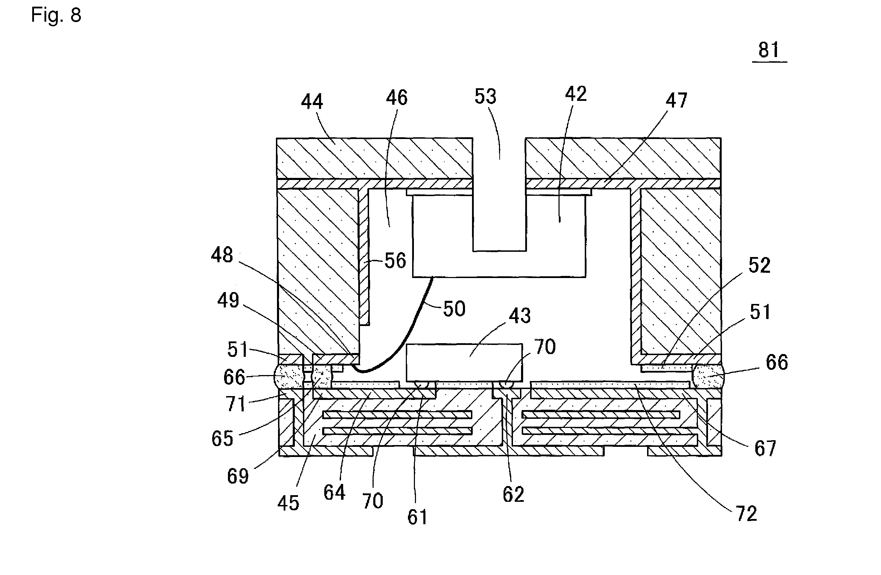

Figs. 7(A), 7(B) and 8 are diagrams for describing a top-port microphone 81 according to Second Embodiment of the present invention. Fig. 8 is a cross-sectional diagram of the microphone 81 according to Second Embodiment of the present invention, and shows a cross section at a portion corresponding to line X2-X2 in Figs. 7(A) and 7(B). Fig. 7(A) is a plan view of a substrate 45 on which a circuit element 43 of the microphone 81 is mounted, and Fig. 7(B) is a bottom view of a cover 44 on which a microphone chip 42 of the microphone 81 is mounted.

According to the microphone 41 of First Embodiment, the circuit element 43 is arranged at the center of the recessed section 46. In contrast, according to the microphone 81 of Second Embodiment, substrate-side joining sections 69 are arranged along one edge of the substrate 45, and the circuit element 43 is arranged at a position closer to the substrate-side joining sections 69 than the center of the recessed section 46 to the extent that no interference is caused with a bonding wire 50.

According to this arrangement, a bump-joining pad 61 of the substrate 45 may be brought closer to the substrate-side joining section 69, and the length of a pattern wiring 64 may be made short. As a result, the length of the wiring connecting the microphone chip 42 and the circuit element 43 may be made even shorter, and there is an advantage that the parasitic capacitance of the cover 44 and the substrate 45 is further reduced and the sensitivity of the microphone 81 is increased, in addition to the effect of the microphone 41 of First Embodiment.

### (Example Modification of Second Embodiment)

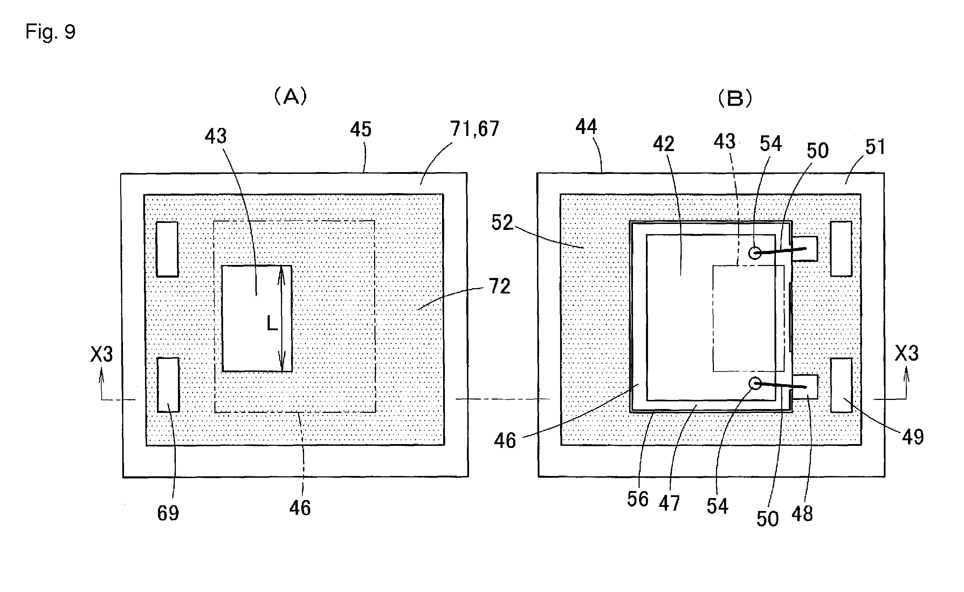

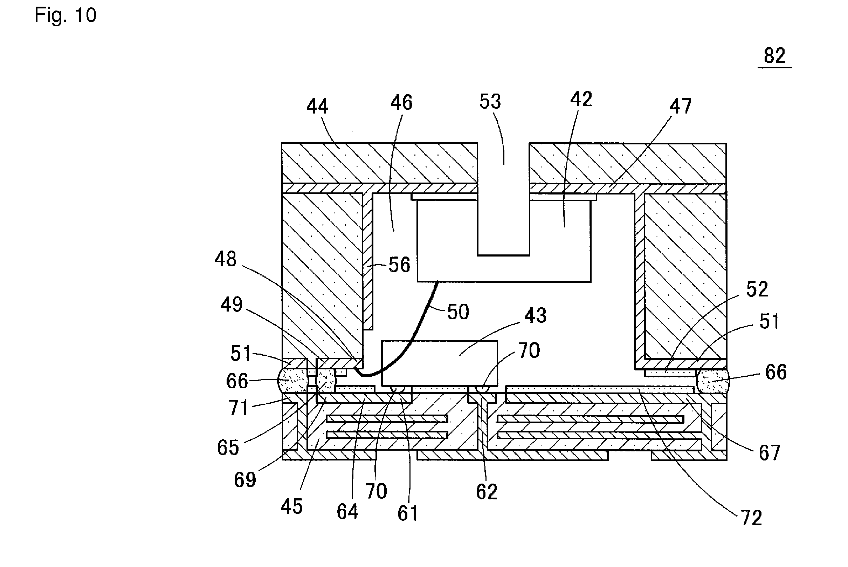

Figs. 9(A), 9(B) and 10 are diagrams for describing a top-port microphone 82 according to an example modification of Second Embodiment of the present invention. Fig. 10 is a cross-sectional diagram of the microphone 82 according to an example modification of Second Embodiment of the present invention, and shows a cross section at a portion corresponding to line X3-X3 in Figs. 9(A) and 9(B). Fig. 9(A) is a plan view of a substrate 45 on which a circuit element 43 of the microphone 82 is mounted. Fig. 9(B) is a bottom view of a cover 44 on which a microphone chip 42 of the microphone 82 is mounted.

As shown in Fig. 9(B), according to this microphone 82, a length L of the circuit element 43 is shorter than the distance between terminals 54 and the distance between bonding pads 48. In this case, as shown in Fig. 10 and Fig. 9(B), the circuit element 43 may be arranged between bonding wires 50 in a way not interfering with the bonding wires 50, and thus, the circuit element 43 may be arranged even closer to a substrate-side joining section 69. As a result, the length of the wiring connecting the microphone chip 42 and the circuit element 43 may be made even shorter, the parasitic capacitance of the cover 44 and the substrate 45 may be even more reduced, and the sensitivity of the microphone 82 may be even more increased.

### (Third Embodiment)

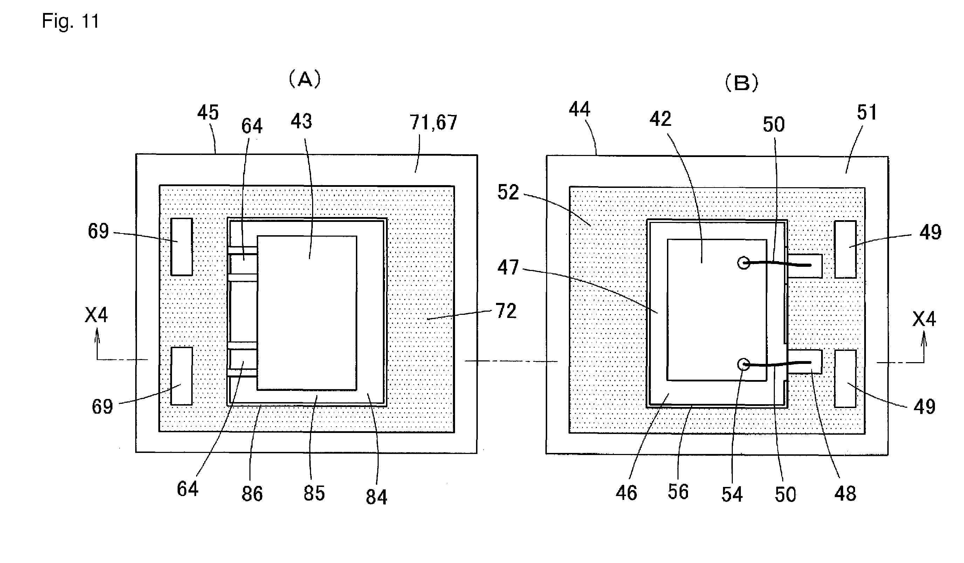

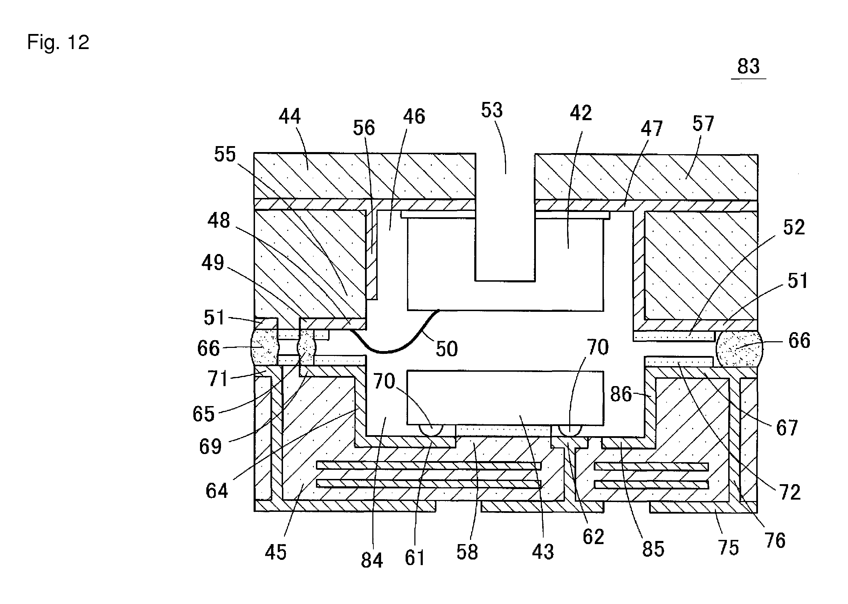

Next, a top-port microphone 83 according to Third Embodiment of the present invention will be described. Fig. 11 (A) is a plan view of a substrate 45 on which a circuit element 43 is mounted, and Fig. 11 (B) is a bottom view of a cover 44 on which a microphone chip 42 is mounted. Fig. 12 is a cross-sectional diagram of the microphone 83 at a portion corresponding to line X4-X4 in Figs. 11 (A) and 11 (B).

In the microphone 83 of Third Embodiment, a substrate 45 including a recessed section 84 is used. As shown in Fig. 11 (B), the cover 44 on which the microphone chip 42 is mounted has the same structure as in the case of First Embodiment.

As shown in Fig. 11 (A), with respect to the substrate 45, a conductive layer 85 is provided on the bottom surface of the recessed section 84, and a conductive layer 86 is provided along the whole perimeter of the inner wall surface of the recessed section 84. The conductive layer 85 at the bottom surface of the recessed section 84 is in conduction with a conductive layer 67 (a ground joining section 71) on the upper surface via the conductive layer 86 on the inner wall surface, and an electromagnetic shield section is configured by these conductive layers 85, 86 and 67. Also, as shown in Fig. 11 (A), the upper surface of the substrate 45 is covered by a solder resist 72 in a frame-like manner, the ground joining section 71 is formed by exposing the outer peripheral portion of the conductive layer 67 from the solder resist 72, and also, a region for mounting the circuit element 43 is formed inside the recessed section 84.

On the bottom surface of the recessed section 84, a bump-joining pad 61 and a bump pad 62 that are insulated from the conductive layer 85 and that are insulated from each other are provided. Also, a bump pad 63 that is in conduction with the conductive layer 85 is provided to the bottom surface of the recessed section 84 (see Fig. 5(A) of First Embodiment). A metal film is provided to the upper surface of the substrate 45 (the upper surface of the region outside the recessed section 84), and a substrate-side joining section 69 and a conductive layer 67 that are insulated from each other are formed by partially removing the metal film. The substrate-side joining section 69 is exposed from the solder resist 72. A pattern wiring 64 is formed from the bottom surface of the recessed section 84 through the inner wall surface to the upper surface of the substrate 45, and the pattern wiring 64 is insulated from the conductive layers 85, 86 and 67. The bump-joining pad 61 and the substrate-side joining section 69 are connected via the pattern wiring 64. Also, the bump pad 62 is in conduction with a signal input/output terminal 77 on the lower surface of the substrate.

As shown in Fig. 12, according to the microphone 83 where the cover 44 and the substrate 45 are stacked, a ground joining section 51 and the ground joining section 71 are joined by a conductive material 66 at the upper surface of the substrate 45. Also, a cover-side joining section 49 and the substrate-side joining section 69 are joined by the conductive material 66 at the upper surface of the substrate 45, and the microphone chip 42 and the circuit element 43 are connected by a bonding wire and the pattern wiring 64.

As in the case of First Embodiment, this microphone 83 also has the advantages that (1) the mounting area may be made small, (2) assembling may be easily performed, (3) suppression of parasitic capacitance of the package and prevention of short-circuiting at the wiring portion may be achieved in a balanced manner by using wiring and bump-connection in combination, (4) the optical noise immunity is improved by flip-chip mounting the circuit element, and (5) a light-shielding resin for covering the circuit element is unnecessary, and the height of the microphone may be reduced and the cost may be reduced.

### (Fourth Embodiment)

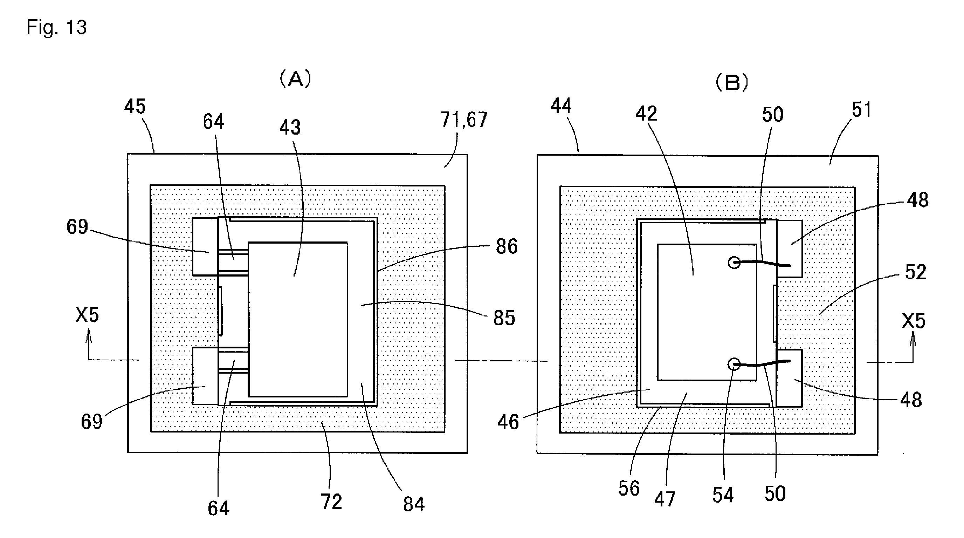

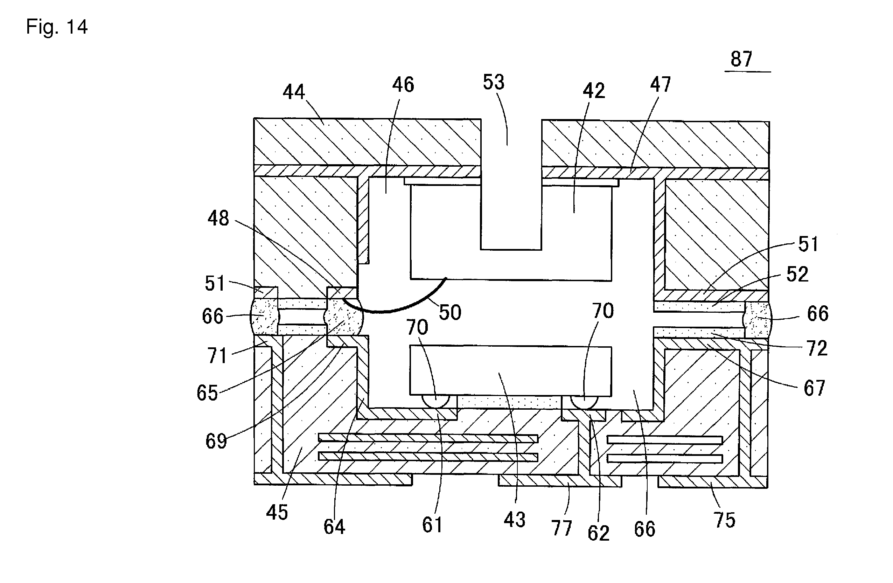

Next, a microphone 87 according to Fourth Embodiment of the present invention will be described. Fig. 13(A) is a plan view of a substrate 45 on which a circuit element 43 is mounted, and Fig. 13(B) is a bottom view of a cover 44 on which a microphone chip 42 is mounted. Fig. 14 is a cross-sectional diagram of the microphone 87 at a portion corresponding to line X5-X5 in Figs. 13(A) and 13(B).

As shown in Fig. 13(B), according to this microphone 87, one end of a bonding wire 50 is connected to a terminal 54 of the microphone chip 42 mounted on the cover 44, and the other end of the bonding wire 50 is connected to a bonding pad 48 of the cover 44. Also, bumps 70 of the circuit element 43 are connected to a bump-joining pad 61 and bump pads 62 and 63, and the bump-joining pad 61 is in conduction with a substrate-side joining section 69 by a pattern wiring 64. Also, as shown in Fig. 14, a bonding pad 48 of the cover 44 and the substrate-side joining section 69 of the substrate 45 are joined by a conductive material 65, and the microphone chip 42 and the circuit element 43 are thereby connected. In Fourth Embodiment, a cover-side joining section 49 is not provided to the cover 44, and a first joining pad is configured only from the bonding pad 48.

### (Fifth Embodiment)

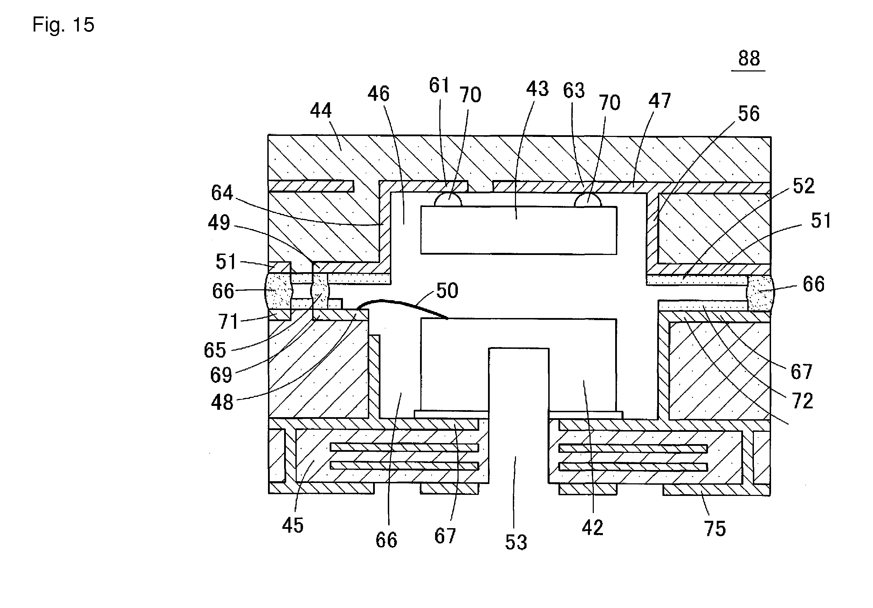

A microphone 88 according to Fifth Embodiment is shown in Fig. 15. This microphone 88 has a circuit element 43 mounted on the lower surface of a cover 44 (a second member), and a microphone chip 42 mounted on the upper surface of a substrate 45 (a first member). In Fig. 22, an acoustic perforation 53 is provided to the substrate 45 to achieve a bottom-port type, but the acoustic perforation 53 may alternatively be provided to the cover 44 to achieve a top-port type.

With the microphone 88, a bonding pad 48 that is in conduction with a substrate-side joining section 69 is provided to the substrate 45, and the substrate-side joining section 69 and the bonding pad 48 form a first joining pad. The other end of a bonding wire 50 that is connected to the microphone chip 42 is connected to the bonding pad 48.

Also, a bump-joining pad 61, a bump pad 62 and a bump pad 63 are provided inside a recessed section 46 of the cover 44, and bumps 70 of the circuit element 43 are connected to the bump-joining pad 61 and the bump pads 62 and 63 in a one-to-one manner. The bump-joining pad 61 is in conduction with a cover-side joining section 49 (a second joining pad) via a pattern wiring 64. Accordingly, by joining the cover-side joining section 49 and the substrate-side joining section 69 by a conductive material 65, the microphone chip 42 and the circuit element 43 are connected. The bump pad 63 is a part of a conductive layer 47, and is connected to the ground. Although not shown in Fig. 15, the bump pad 62 is connected to a signal input/output terminal 77 on the lower surface of the substrate 45 by a pattern wiring, a via hole or the like provided to the cover 44 and the circuit element 43.

### (Others)

Besides the embodiments described above, the present invention may also be applied to the various embodiments described in Japanese Patent Application No. 2010-125527. That is, in each embodiment of the microphone described in Japanese Patent Application No. 2010-125527, the circuit element and the microphone chip are connected by a bonding wire, but the circuit element may be bump-connected in each embodiment. For example, according to the top-port microphone described above, the acoustic perforation 53 is formed on the cover 44 at the position of the microphone chip 42, but the acoustic perforation 53 may be provided to the cover 44 at a position deviated from the microphone chip 42 (for example, the microphone shown in Figs. 9 to 11 in Japanese Patent Application No. 2010-125527). Moreover, a top-port microphone is also allowed according to which the microphone chip 42 is mounted on the substrate 45 and the acoustic perforation 53 is formed on the cover 44.

Also, according to the bottom-port microphone described above, the acoustic perforation 53 is formed on the substrate 45 at the position of the microphone chip 42, but the acoustic perforation 53 may be provided to the substrate 45 at a position away from the microphone chip 42 (for example, the microphone shown in Fig. 3 or Fig. 6 of Japanese Patent Application No. 2010-125527). Furthermore, a bottom-port microphone is also allowed where the microphone chip 42 is mounted on the cover 44, and the acoustic perforation 53 is formed on the substrate 45.

Also, in the case of providing the acoustic perforation 53 at a position deviated from the microphone chip 42 and the circuit element 43, the circuit element 43 may be brought closer to the substrate-side joining section 69 (see Second Embodiment), and also, the microphone chip 42 may be brought closer to the bonding pad 48 to shorten the bonding wire 50, and the acoustic perforation 53 may be arranged at a side farther away from the substrate-side joining section 69 and the bonding pad 48.

In each of the embodiments described above, the microphone chip 42 is connected by the bonding wire 50, and the circuit element 43 is connected by the bumps 70, but it is also possible to connect the circuit element 43 by the bonding wire, and to connect the microphone chip 42 by the bumps. However, if the microphone chip 42 is connected by the bumps 70, acoustic vibration leaks from the gap between the bumps 70, and thus, the microphone chip 42 has to be connected by the bumps 70, and at the same time, the surface where the bumps 70 are provided has to be adhered to the cover 44 and the substrate 45 by an adhesive. Also, in the case of connecting the circuit element 43 by the bonding wire, the optical noise immunity of the circuit element 43 is reduced. Thus, in the case of a microphone, it is desirable that the microphone chip 42 is connected by the bonding wire and the circuit element 43 is connected by the bumps as described above.

Furthermore, the present invention may also be applied to a semiconductor device that uses other than a microphone chip as a sensor. In the case of a semiconductor device that uses other than a microphone chip as a sensor, one of the sensor and a circuit element may be connected by a bonding wire, and the other may be connected by bumps.

## Claims

1. A semiconductor device comprising:
a package formed from a first member and a second member, the package having a space formed inside; and
a sensor and a circuit element that are accommodated inside the package,
wherein a first joining pad is provided at a joining portion of the first member to the second member,
wherein a bump-joining pad for connecting a bump is provided to the second member, and a second joining pad is in conduction with the bump-joining pad is provided to a joining portion of the second member to the first member,
wherein one element among the sensor and the circuit element is mounted on the first member, and the one element and the first joining pad are connected by a wiring,
wherein a bump is provided to another element among the sensor and the circuit element, and the bump is connected to the bump-joining pad and the another element is mounted on the second member,
wherein the sensor and the circuit element are arranged while being at least partially overlapped with each other when seen from a direction vertical to a bottom surface of the package, and
wherein the package is formed by joining the first member and the second member, and the first joining pad and the second joining pad are joined by a conductive material.

2. The semiconductor device according to claim 1, wherein the one element is the sensor, and the another element is the circuit element.

3. The semiconductor device according to claim 1, wherein the second joining pad is arranged on the second member in one direction when seen from the another element, and the another element is arranged at a position closer to the second joining pad than a center of the second member.

4. The semiconductor device according to claim 1,
wherein the first member comprises a plurality of the first joining pads, and the one element and the first joining pads are connected by a plurality of wirings, and
wherein a width of the another element is narrower than a gap between the wirings, and the another element is positioned in the gap between the wirings.

5. The semiconductor device according to claim 1, wherein the bump-joining pad and the second joining pad are connected by a conductive wiring provided to the second member.

6. The semiconductor device according to claim 1,
wherein the first joining pad is formed from a bonding pad provided to the first member at a portion facing the second member, and a joining section in conduction with the bonding pad, and
wherein the wiring is connected to the bonding pad, and the joining section is joined to the second joining pad by the conductive material.

7. The semiconductor device according to claim 6, wherein the bonding pad and the joining section are formed of a continuous metal film, and the bonding pad and the first joining section are separated by partially covering a surface of the metal film by an insulating film.

8. The semiconductor device according to claim 1, wherein the sensor is positioned vertically above or vertically below the circuit element.

9. The semiconductor device according to claim 1, wherein the bump is a solder bump, an Au bump, a bump of other conductive material, or a bump formed of an anisotropic conductive material.

10. The semiconductor device according to claim 1, wherein the first member is a cover of the package, and the second member is a substrate of the package.

11. A microphone, wherein a microphone chip is used as the sensor of the semiconductor device of claim 1, and an acoustic perforation is formed on one of the first member and the second member.
